# EUROPEAN PATENT APPLICATION

(11) **EP 4 297 099 A1**
(43) Date of publication of application: **27.12.2023**
(21) Application number: 23177626.1
(22) Date of filing: 06.06.2023
(51) Int. Cl.: H01L 29/66, H01L 29/786, H01L 21/02, H01L 29/08

(54) **TRANSISTOR WITH CURRENT TERMINAL REGIONS AND CHANNEL REGION IN LAYER OVER DIELECTRIC**

(30) Priority: 24.06.2022 US 202217808857
(71) Applicant: NXP USA, Inc., Austin TX 78735 (US)
(72) Inventor: Magnee, Petrus Hubertus Cornelis, 5656AG Eindhoven (NL); John, Jay Paul, 5656AG Eindhoven (NL)
(74) Representative: Miles, John Richard

(57) **Abstract**

A method includes making a semiconductor die that includes a transistor with a control terminal, and two current terminals. The two current terminals include portions located in a semiconductor layer formed by an epitaxial process on a substrate with semiconductor material and dielectric material. At least some of the portions of the current terminals located in the semiconductor layer are characterized as monocrystalline and are located directly over dielectric material of the substrate. The channel region is located in a monocrystalline portion of the semiconductor layer as well.

## Description

### BACKGROUND OF THE INVENTION

### Field of the Invention

This invention relates in general to transistors with current terminal regions and a channel region in a layer over dielectric material

### Description of the Related Art

Some transistors such as field effect transistors (FETs) include a source and drain regions (current terminal regions for a FET) and a gate (a control terminal for a FET) for controlling the conductivity of a channel region between the source region and drain region.

### BRIEF DESCRIPTION OF THE DRAWINGS

The present invention may be better understood, and its numerous objects, features, and advantages made apparent to those skilled in the art by referencing the accompanying drawings.
Figure 1 is a partial top view of a wafer during a stage in the manufacture of a semiconductor device according to one embodiment of the present invention.
Figures 2-6 are partial cutaway side views of a wafer during various stages in the manufacture of a semiconductor device according to one embodiment of the present invention.

The use of the same reference symbols in different drawings indicates identical items unless otherwise noted. The Figures are not necessarily drawn to scale.

### DETAILED DESCRIPTION

The following sets forth a detailed description of at least one mode for carrying out the invention. The description is intended to be illustrative of the invention and should not be taken to be limiting.

As disclosed herein, a method includes making a semiconductor die that includes a transistor with a control terminal, and two current terminals. The two current terminals include portions located in a semiconductor layer formed by an epitaxial process on a substrate with semiconductor material and dielectric material. At least some of the portions of the current terminals located in the semiconductor layer are characterized as monocrystalline and are located directly over dielectric material of the substrate. The channel region is located in a monocrystalline portion of the semiconductor layer as well.

FETs can be used as switches for high-frequency (RF) signals. Ideally, a switch has very low (near zero) impedance in the on-state and a very high (towards infinity) impedance in the off-state. For some FETs, these two states are characterized by the on-state resistance (RON), and the off-state capacitance, (COFF) respectively. RON can be made smaller by increasing the total width of the transistor, but at a cost of increasing the COFF, leading to a lower impedance, and hence greater losses, in the off-state. Some FETs for switching applications can be implemented in SOI (semiconductor on insulator) substrates, significantly reducing the bottom contribution of the source-to-body and drain-to-body junction capacitance. However, SOI substrates can be more expensive than bulk wafers and may offer limited integration possibilities with other devices, e.g., like vertical SiGe heterojunction bipolar transistors (HBT).

Accordingly, with some embodiments shown herein, the current terminals and channel region of a transistor can be formed in an epitaxially grown semiconductor layer that is formed on dielectric material and exposed semiconductor material defined by an opening in the dielectric material. Portions of the material of the layer directly over the dielectric portion can be converted from a non monocrystalline to a monocrystalline material. Thus, such transistors may be able to be fabricated on non SOI based wafers and still obtain the same reduction in source-to-body and drain-to-body junction capacitance as available with SOI technology. Accordingly, in some embodiments, a similar performance may be achieved while maintaining the advantages of ease of integration with other device types in a standard bulk technology. Furthermore, converting portions of the semiconductor layer from a non monocrystalline structure to a monocrystalline structure, may in some embodiments advantageously provide for a monocrystalline to gate dielectric interface that may reduce defects in the gate dielectric and/or improve leakage current. Furthermore, forming the current terminal regions and the channel region in an epitaxially grown layer including portions formed on the dielectric material may provide for a simplified process that can more easily be integrated with processes for forming other device types.

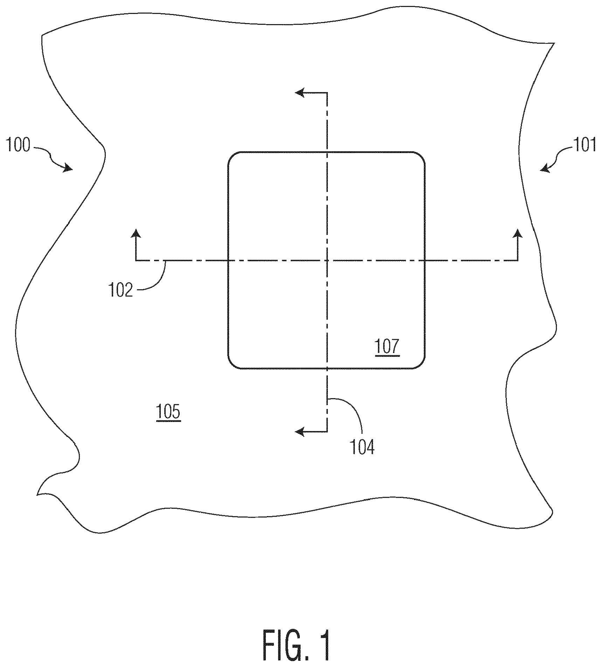

Figure 1 shows a partial top view of a substrate 101 of wafer 100 at a stage in its manufacture according to an embodiment of the present invention. Wafer 100 includes a substrate 101 with a shallow trench isolation structure 105 defining an opening of exposed semiconductor material 107 of substrate 101. In one embodiment, the semiconductor material 107 of substrate 101 is monocrystalline silicon, but may be of other types of semiconductor material such as SiGe, gallium nitride, gallium arsenide, other III-V semiconductor material, or other types of semiconductor material. In some embodiments, substrate 101 may include multiple types of semiconductor material located in different layers or areas of wafer 100. In some embodiments, substrate 101 is cut from a semiconductor ingot, but in other embodiments, substrate may include one or more epitaxially grown layers on a bulk wafer substrate. In some embodiments, the semiconductor material 107 includes conductivity dopants such as N-type dopants (arsenic, phosphorous) or P-type dopants (boron) to form N-type and P-type regions, wells or layers.

STI 105 can be formed on the upper surface of substrate 101 by selectively etching the upper surface to form openings and filing those openings with a dielectric material. However, STI 105 can be formed by other methods such as by a selective oxidation process.

In the view of Figure 1, cross section 102 is located along the length of a subsequently formed transistor and cross section 104 is located along the width of the subsequently formed transistor. In other embodiments, the dimensions of the opening defined by STI 105 may be different including with different ratios of the two perpendicular lateral dimensions of the opening (the vertical dimension and the horizontal dimension relative to the view shown in Figure 1). In other embodiments, the opening may have other shapes (e.g., oval, half oval, circle) or have shapes with multiple openings to implement multiple transistors electrically coupled together on substrate 101.

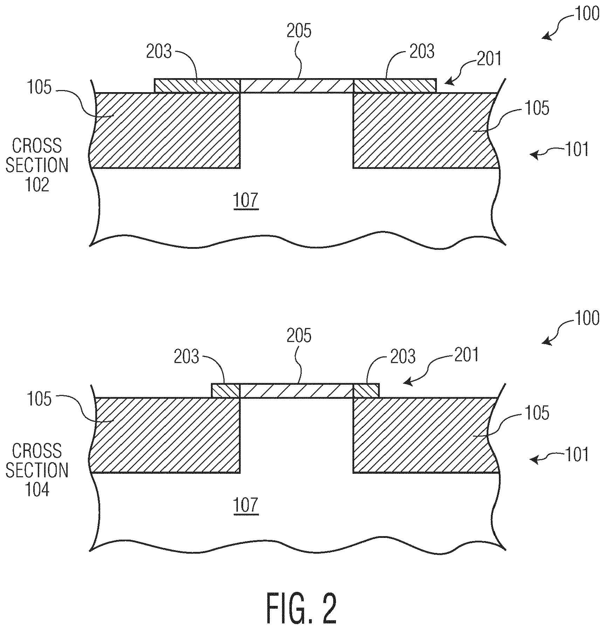

Figure 2 shows side views of partial cutaway cross sections 102 and 104 of wafer 100 at a subsequent manufacturing stage to the stage of Figure 1. After the stage of Figure 1, a patterned semiconductor layer structure 201 is formed on substrate 101. In the embodiment shown, structure 201 is a portion of a semiconductor layer formed on substrate 101 by a non selective epitaxial process where a portion (portion 205) of the semiconductor layer formed on exposed semiconductor material 107 has mono crystalline structure and a portion (portion 203) of the layer formed on dielectric material (STI 105) has a non monocrystalline structure (e.g., polycrystalline or amorphous). In one embodiment, monocrystalline portion 205 has the same lattice constant as semiconductor material 107 of substrate 101. In one embodiment, the layer of structure 201 is made of silicon and is formed by a reduced pressure chemical vapor deposition to a thickness range of 10 - 200 nm, (e.g., 50 nm), but may be formed by other processes, be made of other materials (e.g., SiGe), and/or have other thicknesses in other embodiments.

After the formation of the layer of structure 201, the layer is patterned by a photolithographic process where a patterned photo resist mask (not shown) is formed on the semiconductor layer and the semiconductor layer is then patterned to the shape of structure 201 as shown in Figure 2. As shown in Figure 2, a greater amount of non-monocrystalline material (portion 203) is located over STI 105 in cross section 102 than in cross section 104.

In one embodiment structure 201 is doped with conductivity dopants (e.g., either N-type or P-type depending on the type of transistor (either P-type or N-type) that will be subsequently formed in structure 201). In one embodiment, the conductivity dopants are formed in-situ with the semiconductor layer of structure 201. In other embodiments, the layer may be subsequently implanted with conductivity dopants after formation.

In some embodiments, prior to the stage of Figure 1, a thin sacrificial oxide (not shown) is formed on wafer 100 by either a deposition or oxidation process. Prior to forming the layer of structure 201, the sacrificial oxide layer is removed to expose material 107 that is surrounded by STI 105 as shown in Figure 1. This sacrificial layer may protect other areas of material 107 outside of STI 105 during the patterning to form structure 201. Also in some embodiments, between the stages of Figures 1 and 2, an HF cleaning process and a hydrogen pre bake are performed on wafer 100 prior to the forming of the epitaxially grown semiconductor layer of structure 201. In some embodiments, structure 201 may have a different shape including extending to other regions of wafer 100 where other devices may be subsequently formed.

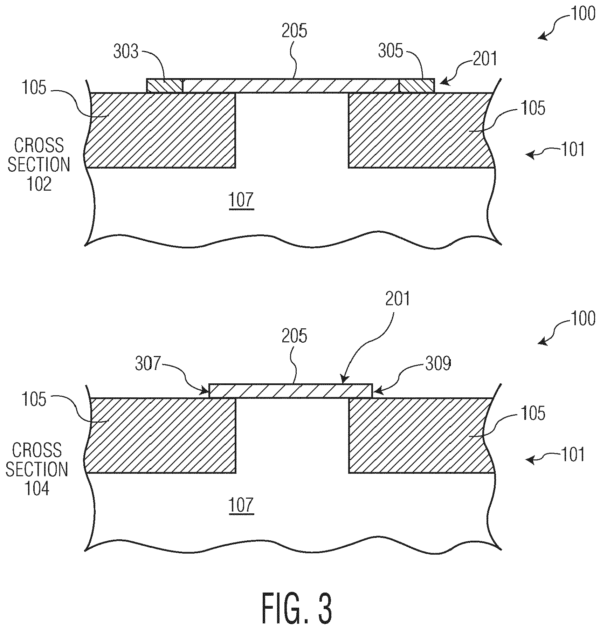

Figure 3 shows side views of partial cutaway cross sections 102 and 104 of wafer 100 after monocrystalline portion 205 of structure 201 is extended by converting portions of the non monocrystalline portion 203 located directly over STI 105 as shown in Figure 2 from having a non monocrystalline structure to having monocrystalline structure. In one embodiment, portions of structure 201 are converted to monocrystalline by subjecting wafer 100 to a solid phase epitaxial regrowth process. In one embodiment of a regrowth process, wafer 100 is heated for one minute at 700 C. Other types of regrowth processes may be performed in other embodiments such as wafer 100 being heated for 15 minutes at 600 C. In some embodiments, monocrystalline portion 205 can be expanded by performing a laser melt annealing process on wafer 100 in selected areas.

In one embodiment where portion 203 has a polycrystalline structure, a blanket amorphizing implant into structure 201 may be performed prior to the epitaxial regrowth process. In one embodiment, germanium dopants are implanted into structure 201 at a dosage of 10¹⁵ and at an energy of 20KeV. However, other implantation operations may be performed at other dosages, other energies, and/or with other types of dopants (e.g., silicon, xenon). In still other embodiments, other portions of wafer 100 may be masked for a selective amorphizing implant so as to avoid implant damage to the masked portions.

As shown in Figure 3, all of the portion of structure 201 shown in cross section 104 is monocrystalline after the conversion process where monocrystalline portions extends from patterned lateral edge 307 to patterned lateral edge 309. Accordingly, the non monocrystalline portions of structure 201 is separated into portion 303 and portion 305 that are located on opposite sides of the expanded portion 205. In some embodiments, all of structure 201 would be converted to a monocrystalline structure.

In the embodiment of Figures 1-3, structure 201 as shown in Figure 3 is formed by forming a layer of semiconductor material by an epitaxial process, patterning the layer to form patterned layer structure 201, and then converting (e.g., by an epitaxial regrowth process) at least some of the portions of layer structure 201 from non monocrystalline to monocrystalline. However, in other embodiments, the conversion process of the portions of layer structure 201 from non monocrystalline to monocrystalline may occur prior to the patterning of the semiconductor layer.

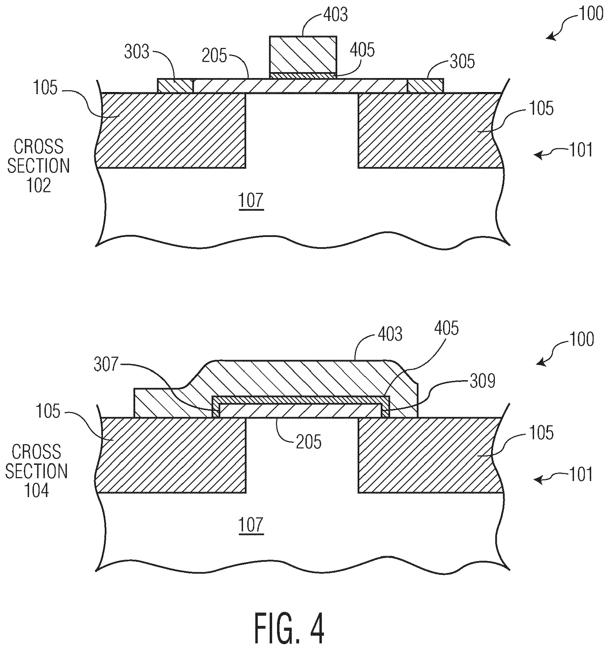

Figure 4 shows side views of partial cutaway cross sections 102 and 104 of wafer 100 after a gate dielectric 405 and gate structure 403 are formed. In one embodiment, gate dielectric 405 is made of an oxide and is formed by oxidizing exposed surfaces of structure 201. In other embodiments, gate dielectric 405 may be formed by a blanket deposition of a gate dielectric material on wafer 100.

In one embodiment, gate structure 403 is formed by forming a blanket layer of gate material (e.g., poly silicon) over wafer 100 and patterning the layer of gate material to the shape of structure 403 shown in Figure 4. In some embodiments, structure 403 may include conductivity dopants (e.g., either implanted or formed in-situ). As shown in cross section 102, gate dielectric 405 is patterned along with the layer of gate material when forming gate structure 403. In some embodiments, gate structure 403 may be made of other gate materials such as metal, as with a replacement gate process.

As shown in cross section 104 of Figure 4, gate structure 403 and gate dielectric 405 cover the portions of the lateral patterned edges 307 and 309. Because the lateral patterned edges 307 and 309 extend out to a location directly over STI 105, gate dielectric 405 does not contact material 107 of substrate 101. In one embodiment, having lateral patterned edges 307 and 309 extend over STI 105 may prevent material 107 from being etched during the patterning of structure 201, thereby leading to a better quality gate oxide.

As shown in Figure, 4 gate dielectric 405 is only located on the portion of structure 201 that is monocrystalline (portion 205). The gate dielectric formed from the oxidation of monocrystalline portion 205 is of a higher quality than if it were formed from the oxidation of non-monocrystalline silicon (e.g., poly silicon). For example, an oxide grown on a grain boundary of poly silicon may be of a poorer quality. Accordingly, providing a semiconductor structure 201 with monocrystalline portions located on dielectric material may provide for an improve gate oxide in those areas. In addition, because the portions of structure 201 at edges 307 and 309 shown in cross section 104 are monocrystalline, there would be no grain boundaries running from portion 303 to portion 305, which would reduce the possibility of drain to source leakage current.

Also, because gate structure 403 is located directly over the monocrystalline portion 205 of structure 201 and not directly over the non monocrystalline portions of structure 201, the subsequently formed transistor may exhibit less leakage current during operation in that current would not leak through grain boundaries in a non-monocrystalline portion of structure 201 to the gate structure 402 as it would with a polysilicon portion of structure 201. Accordingly, providing a semiconductor structure (201) with monocrystalline portions (205) located directly over dielectric material (STI 105) may provide for a transistor with less leakage current.

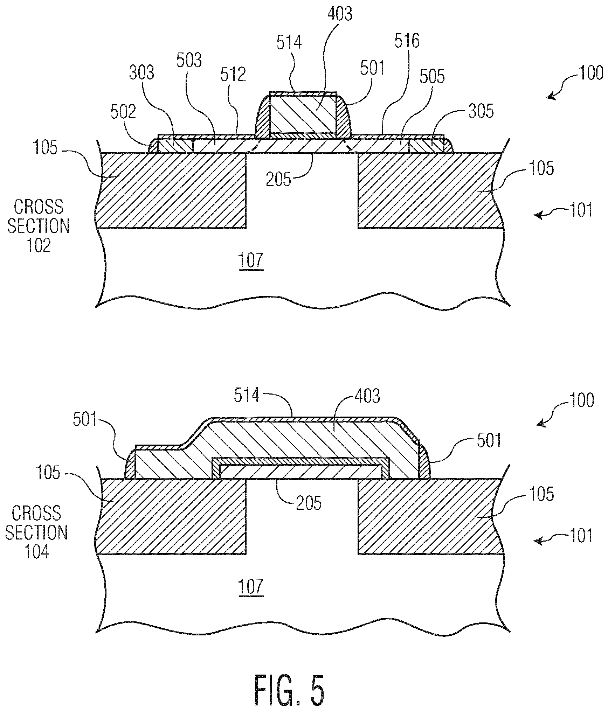

Figure 5 shows side views of partial cutaway cross sections 102 and 104 of wafer 100 after source region 503, drain region 505, side wall spacers 501 and 502, and silicide structures 512, 514, and 516 are formed. Gate side wall spacer 501 and structure side wall spacer 502 are formed by the deposition of one of more layers of dielectric material (e.g., oxide, nitride) over wafer 100 followed by an anisotropic etch of the one or more dielectric layers.

Source region 503 and drain region 505 are then formed by the selective implantation of conductivity dopants into structure 201 where gate structure 403 and spacer 501 serve as an implantation mask. Either N-type dopants or P-type dopants are implanted into selective regions of structure 201 depending upon whether the transistor to be formed is an N-type transistor or a P-type transistor.

As shown in Figure 5, source region 503 includes portions of monocrystalline portion 205 and non-monocrystalline portion 303. Drain region 505 includes portions of monocrystalline portion 205 and non-monocrystalline portion 305. In other embodiments where all of structure 201 is mono crystalline, regions 503 and 505 would entirely monocrystalline. Also in some embodiments, regions 503 and 505 may each include lightly doped extension regions (not shown) located under gate spacer 501 that are formed by the implantation of conductivity dopants into structure 201 prior to the formation of gate spacer 501.

After the formation of source region 503 and drain region 505, wafer 100 is subject to a silicidation process where a metal (e.g., titanium, cobalt, or nickel) is deposited on wafer 100 and heated such that a silicide forms on exposed silicon surfaces. The unreacted metal is subsequently removed. As a result of the silicidation process, silicide structure 512 is formed on source region 503, silicide structure 514 is formed on gate structure 403, and silicide structure 516 is formed on drain region 505.

In some embodiments where portions 303 and 305 initially have an amorphous structure, the heating processes occurring during fabrication, e.g., during dopant activation or silicidation, may convert portions 303 and 305 to polysilicon.

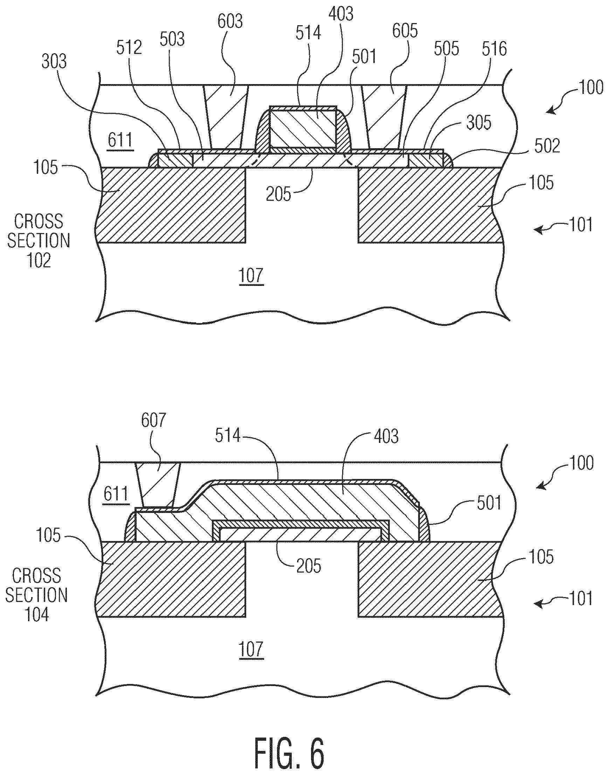

Figure 6 shows side views of partial cutaway cross sections 102 and 104 of wafer 100 after a subsequent stage in its manufacture. After the stage of Figure 5, one or more dielectric layers 611 are formed on wafer 100 and planarized. Openings are then formed to contact the silicide structures. Contact metal (e.g., tungsten, titanium, titanium nitride) is then formed in the openings where wafer 100 is planarized to form contacts for the terminals of wafer 100. For example, contact 603 is formed to contact source silicide structure 512, contact 605 is formed to contact drain silicide structure 516 (see cross section 102) and contact 607 is formed to contact gate silicide structure 514 (see cross section 104).

In the embodiment shown, source contact 603 contacts an area of silicide structure 512 that is located directly over the monocrystalline portion of source 305 and drain contact 605 contacts an area of silicide structure 516 that is located directly over the monocrystalline portion of drain region 505. In one embodiment, having the source and drain contacts located directly over monocrystalline portions of the source and drain regions respectively, provides for a monocrystalline path from source region to drain region through structure 201. Such a monocrystalline path may provide for a lower on resistance for a transistor.

Accordingly, cross section 102 of Figure 6 shows a cross section of a FET that includes a source region 503 (including polysilicon portion 303), a gate (gate structure 403), and a drain region 505 (including polysilicon portion 305). A channel region is located directly under gate structure 403 in portion 205 and extends between the source region 503 and the drain region 505. A channel region is a semiconductor region in which carriers (e.g., holes, electrons) conduct between current terminal regions of the transistor when a conduction voltage is applied to the control terminal of the transistor.

After the stage of manufacture shown in Figure 6, subsequent processes may be performed on wafer 100. For example, upper interconnect layers (not shown) may be formed on top of wafer 100 and include conductive structures electrically coupled to the contacts for the gate structure, source region, and drain region of the transistor of Figure 6 as well as to the contacts of other devices formed on wafer 100. Afterwards, wafer 100 is separated into multiple semiconductor dies each with at least one transistor similar to the transistor shown in Figure 6. The die are protected in semiconductor packages that can be implemented in electronic systems such as e.g., RF communications devices, motor controllers, automotive electronics systems, or cellular phones. In one example, the transistor is used as a high frequency switch in a communications system, but may be used in other types of circuits.

The transistors describe herein may have other configurations, have other structures, be made of other materials, and/or be made by other processes. For example, in some embodiments, the source region may surround or partially surround the drain region. Also in other embodiments, the ratio of the length or width of the gate structure 403 versus the width of the opening of STI 105 as shown in cross section 102 or in cross section 104 of Figure 6 may be of different values. For example, in the view of cross section 102 or cross section 104 of Figure 6, the opening in STI 105 may be narrower or wider. In other embodiments, the processes described herein may be utilized to form other types of transistors.

In one embodiment, other devices may be formed on wafer 100. For example, other types of transistors such as planar FETs, FinFETs, and bipolar transistors may be formed with at least some terminals located in the semiconductor material 107 of substrate 101.

In the embodiment shown, semiconductor structure 201 can be formed without a mechanical planarization of its surface. In some embodiments, this may allow for a higher quality gate oxide (405) to be formed on structure 201 due to its top surface not being mechanically planarized.

In some embodiments, the current terminal regions and channel region can each be formed in a layer (e.g., the layer of structure 201) that's formed on dielectric material (e.g., STI 105 in the embodiment shown). In some embodiments, this may simplify the process for forming a transistor in reducing the steps from examples where portions of the transistor are formed in differently constructed layers of a wafer. Furthermore, it may aid in the integration of the formed transistor with the formation of other types of transistors (e.g., bipolar, planar CMOS in bulk) on other parts of the wafer. For example, forming the current terminal and channel regions in an epitaxially grown layer of the wafer may minimize the processing on other parts of the wafer where other types of transistors are formed.

As disclosed herein, a first structure is "directly over" a second structure if the first structure is located over the second structure in a line having a direction that is perpendicular with a generally planar major side of the wafer or substrate. For example, in Figure 6, cross section 102, contact 603 is directly over region 503. Contact 605 is not directly over region 503. As disclosed herein, a first structure is "directly beneath" or "directly under" a second structure if the first structure is located beneath the second structure in a line having a direction that is perpendicular with a generally planar major side of the wafer or substrate. For example, in Figure 6, cross section 102, region 503 is directly beneath contact 603. Region 503 is not directly beneath contact 605. One structure is "directly between" two other structures in a line if the two structures are located on opposite sides of the one structure in the line. For example, in Figure 6, gate structure 403 is located directly between contacts 603 and 605 in a line in the cut away side view of Figure 6, cross section 102. Portion 205 is not located directly between contacts 603 and 605 in the view of Figure 6, cross section 102. A first structure is "directly lateral" to a second structure if the first structure and second structure are located in a line having a direction that is parallel with a generally planar major side of the wafer or substrate. For example, contact 603 and contact 605 are directly lateral to each other. One structure is "directly laterally between" two other structures if the two structures are located on opposite sides of the one structure in a line that is parallel with a generally planar major side of the wafer or substrate. For example, in Figure 6, cross section 102, gate structure 403 is located directly laterally between contacts 605 and 603. A surface is at a "higher elevation" than another surface if that surface is located closer to the top of the active side of a wafer or die in a line having a direction that is perpendicular with the generally planar major side of the wafer or die. In the view of Figure 6, the active side of the wafer is the top side of the Figures. For example, gate structure 403 is at a higher elevation than STI 105.

In a first aspect of a method for forming a semiconductor die including a transistor, the method includes on a wafer including a substrate with semiconductor material and dielectric material wherein the dielectric material of the substrate defines an opening on a surface of the substrate with exposed semiconductor material, forming an epitaxially grown semiconductor layer on the substrate. The epitaxially grown semiconductor layer includes a monocrystalline portion located directly over the opening and extending laterally across the opening to locations located directly over the dielectric material. The method includes forming a control terminal for a transistor including a portion located directly over the monocrystalline portion of the epitaxially grown semiconductor layer and forming a first current terminal region of the transistor in the epitaxially grown semiconductor layer. At least a portion of the first current terminal region is located in the monocrystalline portion located directly over the dielectric material. The method includes forming a second current terminal region of the transistor in the epitaxially grown semiconductor layer. At least a portion of the second current terminal region is located in the monocrystalline portion located directly over the dielectric material. The monocrystalline portion of the epitaxially grown semiconductor layer includes a channel region extending between the first current terminal region and the second current terminal region and directly beneath the control terminal. The method includes separating the wafer into a plurality of die including a first die, wherein the first die includes the transistor.

In a second aspect of a method for forming a semiconductor die including a transistor, the method includes forming a layer of semiconductor material by an epitaxial process on a substrate of a wafer where semiconductor material of the layer formed on a monocrystalline portion of the substrate has a monocrystalline structure and semiconductor material of the layer formed on dielectric material of the substrate has a non monocrystalline structure. The method includes after the forming the layer, converting portions of the layer having a non monocrystalline structure to having a monocrystalline structure. The method includes forming a control terminal of a transistor directly over the layer, forming a first current terminal region of the transistor in the layer including in a portion of the layer that was converted from having a non monocrystalline structure to having mono crystalline structure, and forming a second current terminal region of the transistor in the layer including in a portion of the layer that was converted from having a non monocrystalline structure to having monocrystalline structure. A portion of the layer having a monocrystalline structure includes a channel region that extends in the layer from the first current terminal region to the second current terminal region. The method includes separating the wafer into a plurality of die including a first die, wherein the first die includes the transistor.

In some embodiments, patterning the layer to define lateral patterned edges of a remaining portion of the layer before the forming the first current terminal region and the second current terminal region.

In some embodiments, wherein after the converting and after the patterning, the monocrystalline portion extends to at least a portion of a first patterned lateral edge of the layer located directly over the dielectric material and to at least a portion of a second patterned lateral edge of the layer located directly over the dielectric material, the first patterned lateral edge being and opposite lateral edge to the second patterned lateral edge of the remain portion of the layer. In some embodiments, the method further comprises: forming a first current terminal contact directly over a portion of the first current terminal region that is located in a monocrystalline portion of the layer located directly over the dielectric material; forming a second current terminal contact directly over a portion of the second current terminal region that is located in a monocrystalline portion of the layer located directly over the dielectric material.

In some embodiments, the method further comprises: patterning the layer to define patterned lateral edges of a remaining portion of the layer; after patterning the layer, oxidizing the layer to form a control terminal dielectric on the layer; wherein at least a portion of the control terminal dielectric is removed in forming the control terminal, and the control terminal includes a portion located directly over a remaining portion of the control terminal dielectric.

In another embodiment of a method for forming a semiconductor die including a transistor, the method includes on a wafer including a substrate with semiconductor material and dielectric material, wherein the dielectric material of the substrate defines an opening on a surface of the substrate with exposed semiconductor material, forming a semiconductor structure over the substrate. The semiconductor structure includes a monocrystalline portion located directly over the opening. The monocrystalline portion extends to at least a portion of a first patterned lateral edge of the semiconductor structure located over the dielectric material and to at least a portion of a second patterned lateral edge of the semiconductor structure located over the dielectric material. The first patterned lateral edge being an opposite lateral edge to the second patterned lateral edge of the semiconductor structure. The semiconductor structure is formed by patterning an epitaxially grown semiconductor layer on the substrate. The method includes forming a control terminal for a transistor over the semiconductor structure. The control terminal located directly over the portion of the first patterned lateral edge and the portion of the second patterned lateral edge. The method includes forming a first current terminal region of the transistor in the semiconductor structure. The forming the first current terminal region includes implanting conductivity dopants into a third portion of the semiconductor structure not covered by the control terminal. The method includes forming a second current terminal region of the transistor in the semiconductor structure. The forming the second current terminal region includes implanting conductivity dopants into a fourth portion of the semiconductor structure not covered by the control terminal. The monocrystalline portion of the semiconductor structure includes a channel region extending between the first current terminal region and the second current terminal region in the monocrystalline portion and directly beneath the control terminal. The method includes separating the wafer into a plurality of die including a first die, wherein the first die includes the transistor.

In some embodiments, an epitaxial regrowth process is performed on material of the epitaxially grown semiconductor layer after the forming the epitaxially grown semiconductor layer to convert portions of the epitaxially grown semiconductor layer located directly over the dielectric material of the substrate defining the opening from having a non monocrystalline structure to having monocrystalline structure.

In some embodiments, the first current terminal region includes a portion of the semiconductor structure that was converted from having a non monocrystalline structure to having monocrystalline structure;

In some embodiments, the second current terminal region includes a portion of the semiconductor structure that was converted from having a non monocrystalline structure to having monocrystalline structure.

In some embodiments, the first current terminal region includes a portion located directly over dielectric material defining the opening that is monocrystalline and the second current terminal region includes a portion located directly over the dielectric material defining the opening that is monocrystalline.

In some embodiments, the method further comprises: after patterning the epitaxially grown semiconductor layer, oxidizing the semiconductor structure to form a control terminal dielectric on the layer; wherein the control terminal dielectric is formed on a sidewall of the portion of the first patterned lateral edge of the semiconductor structure located over the dielectric material and on a sidewall of the portion of the second patterned lateral edge of the semiconductor structure located over the dielectric material; wherein the control terminal includes a first portion located directly laterally adjacent to the control terminal dielectric formed on the sidewall of the portion of the first patterned lateral edge of the semiconductor structure and a second portion located directly laterally adjacent to the control terminal dielectric formed on the sidewall of the portion of the second patterned lateral edge of the semiconductor structure.

A method includes making a semiconductor die that includes a transistor with a control terminal, and two current terminals. The two current terminals include portions located in a semiconductor layer formed by an epitaxial process on a substrate with semiconductor material and dielectric material. At least some of the portions of the current terminals located in the semiconductor layer are characterized as monocrystalline and are located directly over dielectric material of the substrate. The channel region is located in a monocrystalline portion of the semiconductor layer as well.

Features specifically shown or described with respect to one embodiment set forth herein may be implemented in other embodiments set forth herein.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the true spirit and scope of this invention.

## Claims

1. A method for forming a semiconductor die including a transistor, the method comprising:
on a wafer including a substrate with semiconductor material and dielectric material wherein the dielectric material of the substrate defines an opening on a surface of the substrate with exposed semiconductor material, forming an epitaxially grown semiconductor layer on the substrate, the epitaxially grown semiconductor layer includes a monocrystalline portion located directly over the opening and extending laterally across the opening to locations located directly over the dielectric material;
forming a control terminal for a transistor including a portion located directly over the monocrystalline portion of the epitaxially grown semiconductor layer;
forming a first current terminal region of the transistor in the epitaxially grown semiconductor layer, wherein at least a portion of the first current terminal region is located in the monocrystalline portion located directly over the dielectric material,
forming a second current terminal region of the transistor in the epitaxially grown semiconductor layer, wherein at least a portion of the second current terminal region is located in the monocrystalline portion located directly over the dielectric material, wherein the monocrystalline portion of the epitaxially grown semiconductor layer includes a channel region extending between the first current terminal region and the second current terminal region and directly beneath the control terminal;
separating the wafer into a plurality of die including a first die, wherein the first die includes the transistor.

2. The method of claim 1 wherein:
the forming the epitaxially grown semiconductor layer includes forming the epitaxially grown semiconductor layer by a non selective epitaxial process where a portion of the epitaxially grown semiconductor layer directly over the opening has a monocrystalline structure and portions of the epitaxially grown semiconductor layer directly over dielectric material have a non monocrystalline structure when formed by the non selective epitaxial process.

3. The method of claim 2 wherein the forming the epitaxially grown semiconductor layer further includes converting portions of the epitaxially grown semiconductor layer having a non monocrystalline structure to having a monocrystalline structure after the performance of the non selective epitaxial process to extend the monocrystalline portion to areas located directly over the dielectric material of the substrate.

4. The method of claim 3 further comprising:
patterning the epitaxially grown semiconductor layer to define patterned lateral edges of a remaining portion of the epitaxially grown semiconductor layer;
wherein the converting is performed after the patterning but before the forming the first current terminal region and the second current terminal region.

5. The method of claim 3 further comprising:
patterning the epitaxially grown semiconductor layer to define patterned lateral edges of a remaining portion of the epitaxially grown semiconductor layer;
wherein the converting is performed before the patterning, before the forming the first current terminal region, and before the forming the second current terminal region.

6. The method of any preceding claim, wherein the first current terminal region includes a second portion located directly over dielectric material that is non monocrystalline and the second current terminal region includes a second portion located directly over the dielectric material that is non monocrystalline.

7. The method of any preceding claim, wherein the monocrystalline portion extends to at least a portion of a first patterned lateral edge of the epitaxially grown semiconductor layer located directly over the dielectric material and to at least a portion of a second patterned lateral edge of the epitaxially grown semiconductor layer located directly over the dielectric material, the first patterned lateral edge being an opposite lateral edge to the second patterned lateral edge.

8. The method of claim 7 wherein the control terminal is located directly over the portion of the first patterned lateral edge of the epitaxially grown semiconductor layer located directly over the dielectric material and located directly over the portion of the second patterned lateral edge of the epitaxially grown semiconductor layer located directly over the dielectric material.

9. The method of any preceding claim, wherein the transistor is characterized as a field effect transistor.

10. The method of any preceding claim further comprising:
forming a first current terminal contact directly over the at least a portion of the first current terminal region that is located in the monocrystalline portion located directly over the dielectric material;
forming a second current terminal contact directly over the at least a portion of the second current terminal region that is located in the monocrystalline portion located over the dielectric material.
